# DEMANDE DE BREVET EUROPEEN

(11) **EP 4 202 076 A1**
(43) Date de publication de la demande: **28.06.2023**
(21) Numéro de dépôt: 22203020.7
(22) Date de dépôt: 21.10.2022
(51) Int. Cl.: C23C 14/58, C23C 14/34, C23C 14/14, C23C 14/00, C23C 14/02, A44C 27/00, C25D 7/00, G04B 37/22, G04B 19/12, G04B 45/00

(54) **PROCÉDÉ DE DÉPÔT D'UN REVÊTEMENT SUR UN SUBSTRAT**

(30) Priorité: 21.12.2021 EP 21216468
(71) Demandeur: Omega SA, 2502 Bienne (CH)
(72) Inventeur: CURCHOD, Loïc, 1004 Lausanne (CH); SPRINGER, Simon, 3007 Berne (CH); LAUPER, Stéphane, 2016 Cortaillod (CH); ODEH, Ahmad, 1020 Renens (CH); GSTALTER, Marion, 25570 Grand'Combe Châteleu (FR); OBERSON, Loïc, 1110 Morges (CH); KISSLING, Gregory, 2520 La Neuveville (CH)
(74) Mandataire: ICB SA

(57) **Abrégé**

L'invention concerne un procédé de dépôt d'un revêtement sur un substrat (100), ledit procédé étant caractérisé en ce qu'il comporte une étape de dépôt d'une couche mince intermétallique (110) sur ledit substrat (100), de sorte à obtenir, à l'issue de cette étape, une pièce d'habillage (10) présentant une couleur finale prédéterminée.

## Description

### Domaine technique de l'invention

L'invention relève du domaine des matériaux, et notamment des matériaux définissant l'aspect extérieur de pièces d'habillage d'horlogerie, de bijouterie, d'articles de mode, ou plus généralement d'objets divers.

Plus particulièrement, l'invention concerne un procédé de dépôt d'un revêtement sur un substrat.

### Arrière-plan technologique

Les dépôts de couches minces sous atmosphère contrôlée sont couramment utilisés dans l'industrie en général et dans les domaines horloger et bijoutier en particulier, pour réaliser des revêtements ayant des applications esthétiques et/ou techniques.

Pour les applications esthétiques, les couches minces déposées peuvent être composées de métaux nobles, tels que l'or (Au) et l'argent (Ag), ou d'alliages de métaux nobles. Ces alliages de métaux nobles sont souvent composés d'une combinaison d'or, d'argent et de cuivre (Cu), avec éventuellement des ajouts de platine (Pt) ou d'autres métaux voisins. Dans ces alliages de métaux nobles, les atomes forment des liaisons métalliques qui sont à l'origine de la couleur de l'alliage et de sa malléabilité.

Parmi les méthodes de dépôt de couches minces couramment utilisées se trouvent les méthodes de dépôt physique en phase vapeur (connues sous le sigle en langue anglaise « PVD », pour « Physical Vapor Déposition ») comprenant notamment la méthode de la pulvérisation cathodique et les méthodes d'évaporation ; les méthodes de dépôt chimique en phase vapeur (connues sous le signe en langue anglaise « CVD » pour « Chemical Vapor Déposition ») ; les méthodes de dépôt de métaux par croissance galvanique ; et les méthodes de dépôt de couches minces atomiques (connues sous le sigle en langue anglaise « ALD », pour « Atomic Layer Déposition »).

Il existe en outre des composés intermétalliques, notamment de métaux nobles, offrant une palette de couleurs élargie par rapport aux alliages nobles standards précités. Par exemple, les composés intermétalliques Pt-Al jaune, Pt-Al-Cu orange ou rose, Au-AI bleu, Au-In violet.

Dans ces composés intermétalliques, les atomes forment des liaisons covalentes fortes qui sont à l'origine des couleurs particulières de ces composés, mais qui les rendent durs et cassants sous leur forme massive. Ces composés intermétalliques sont donc difficilement exploitables et effectivement peu exploités sous leur forme massive car peu malléables et difficiles à mettre en forme.

Ces composés intermétalliques peuvent néanmoins être exploités sous forme de couches plus ou moins minces en mettant en oeuvre une des méthodes de dépôt de couches minces sous vide précitées.

Par exemple, ces méthodes de dépôt peuvent être mises en œuvre pour déposer des couches minces de composés intermétalliques formés à partir de métaux tels que Au, Al, Cu, In ou Pt, comme les composés AuAl₂ et PtAl₂.

Néanmoins, les couches minces de composés intermétalliques déposées par ces méthodes sont hors équilibre thermodynamique et présentent une phase principalement amorphe qui n'a pas la couleur désirée que lesdits composés intermétalliques de mêmes compositions ont sous leur forme massive et cristalline, mais typiquement une couleur grise sans intérêt esthétique particulier.

En effet, l'état thermodynamique des composés intermétalliques, et en particulier leur cristallinité et/ou la présence de différentes phases, a un impact majeur sur leur couleur pour une composition donnée.

Une étape de recuit de la couche in situ pendant le procédé de dépôt, typiquement à 400°C, est donc mise en œuvre pour provoquer une cristallisation au moins partielle de la couche de composé intermétallique ainsi déposée et obtenir la coloration de la couche qui est propre à la phase cristalline dudit composé intermétallique pour la composition donnée.

Les couches minces de composés intermétalliques restent en pratique très peu employées dans la mesure où, bien qu'elles offrent des alternatives intéressantes en terme de choix de couleurs par rapport aux couches minces d'alliages nobles standards, la mise en œuvre de la méthode pour les déposer est longue et complexe du fait de la nécessité de réaliser un recuit in situ des couches minces.

### Résumé de l'invention

La présente invention résout les inconvénients précités.

À cet effet, l'invention concerne un procédé de dépôt d'un revêtement sur un substrat, ledit procédé comportant une étape de dépôt, typiquement à moins de 100°C, d'une couche mince intermétallique sur ledit substrat, ladite couche mince étant formée d'un composé intermétallique dont la composition est choisie de sorte à obtenir, à l'issue de cette étape, une pièce d'habillage d'horlogerie, de bijouterie ou d'articles de mode présentant une couleur finale prédéterminée.

La couleur finale de la couche intermétallique étant obtenue directement à la suite du dépôt de la couche mince intermétallique, dans une phase principalement amorphe, faiblement cristalline, il n'est pas nécessaire d'appliquer une étape de recuit à la pièce d'habillage pour cristalliser la couche mince intermétallique.

Avantageusement, grâce à l'invention, la pièce d'habillage est réalisée dans un temps considérablement réduit. Par ailleurs, le procédé peut être mis en œuvre sur des substrats sensibles aux températures élevées, c'est-à-dire, des substrats pour lesquels la mise en œuvre d'une étape de recuit aurait engendré une déformation plastique, voire une rupture.

Dans des modes particuliers de mise en œuvre, l'invention peut comporter en outre l'une ou plusieurs des caractéristiques suivantes, prises isolément ou selon toutes les combinaisons techniquement possibles.

Dans des modes particuliers de mise en œuvre, l'étape de dépôt de la couche mince intermétallique est réalisée par la mise en œuvre d'une méthode de dépôt PVD parmi la pulvérisation cathodique ou ionique, l'évaporation thermique, l'évaporation par faisceau d'électrons ou par arc, ou l'ablation par faisceau laser pulsé.

Dans des modes particuliers de mise en œuvre, le dépôt de la couche mince est réalisé à partir d'au moins une cible composée d'un composite d'au moins deux métaux ou d'au moins deux cibles de métaux purs différents. Dans le cas de l'utilisation de cibles de métaux purs, le dépôt de la couche mince est réalisé par co-pulvérisation cathodique (connue sous le terme « co-sputtering » en langue anglaise), c'est-à-dire par pulvérisation cathodique simultanée des au moins deux cibles de métaux purs différents, le composé intermétallique se formant alors à la rencontre des au moins deux flux d'atomes sur le substrat. Alternativement, le dépôt de la couche mince est réalisé par co-évaporation, i.e. par évaporation simultanée des au moins deux cibles (par exemple en forme de poudre ou granulés dans un creuset ou équivalent) de métaux purs différents, le composé intermétallique se formant alors à la rencontre des flux d'atomes provenant des au moins deux cibles sur le substrat. Les puissances appliquées sur les au moins deux cibles sont choisies de manière indépendante de sorte que les taux de pulvérisation des au moins deux différents métaux résultent en la composition de couche désirée. Néanmoins, le taux de dépôt des métaux varie en fonction de l'usure des cibles correspondantes et la composition de la couche dérive en conséquence au fur et à mesure de l'exploitation desdites cibles. Ces variations de taux de dépôt peuvent être compensées par une correction de la puissance appliquée sur chacune des cibles en fonction de leur usure, soit manuellement sur la base d'un tableau de calibration, soit automatiquement grâce à une boucle de rétroaction basée sur une mesure in situ (par exemple, une mesure spectrale de l'émission optique du plasma dans le cas de la pulvérisation cathodique).

Dans le cas de l'utilisation d'une cible composite, la composition de ladite cible est choisie de manière à obtenir directement la composition de couche désirée sur le substrat, avec l'avantage de ne pas dépendre de l'usure de ladite cible composite.

Dans des modes particuliers de mise en œuvre, l'étape de dépôt est réalisée de sorte que la couche mince intermétallique présente une épaisseur comprise entre 20 et 1000 nm, de préférence entre 200 et 500 nm, et plus préférentiellement de 300 nm.

Dans des modes particuliers de mise en œuvre, le procédé comprend une étape de recuit localisé sur une zone prédéterminée de la couche mince intermétallique de sorte à la cristalliser localement et modifier localement la couleur finale de la pièce d'habillage. On obtient ainsi un contraste de couleurs entre la zone non-recuite, faiblement amorphe et colorée, et la zone recuite, cristallisée et grise.

Dans des modes particuliers de mise en œuvre, l'étape de recuit localisé est réalisée par le biais d'un laser dont le faisceau présente un diamètre compris entre 10 µm et 100 µm, voire entre 50 µm et 100 µm.

Dans des modes particuliers de mise en œuvre, l'étape de recuit localisé est réalisée par le biais d'un laser configuré pour émettre des impulsions dont la durée est comprise entre 4 ns et 350 ns, de fréquence variable entre 10 kHz et 1 MHz.

Dans des modes particuliers de mise en œuvre, l'opération de recuit localisé est réalisée à atmosphère ambiante ou dans une enceinte sous atmosphère protectrice d'un gaz inerte, i.e. l'argon (Ar), ou sous vide afin d'éviter toute interaction chimique entre la couche mince intermétallique et l'atmosphère.

Dans des modes particuliers de mise en œuvre, l'étape de dépôt de la couche mince intermétallique peut être précédée d'une étape de structuration de surface dans laquelle la surface du substrat est structurée, par exemple sur seulement une partie.

Dans des modes particuliers de mise en œuvre, lors de l'étape de structuration, une partie de la surface du substrat est structurée, ladite partie correspondant à la zone prédéterminée soumise à l'étape de recuit localisé, un contraste d'aspect de surface s'additionnant alors au contraste de couleur.

Dans des modes particuliers de mise en œuvre, lors de l'étape de structuration, la structuration est réalisée sur l'ensemble de la surface du substrat qui sera couverte par la couche mince intermétallique.

Dans des modes particuliers de mise en œuvre, le procédé comprend, à la suite de l'étape de dépôt de couche mince intermétallique et de l'éventuelle étape de recuit localisé, une étape de dépôt d'une couche de protection de la couche mince intermétallique contre les agressions de l'environnement.

Dans des modes particuliers de mise en œuvre, lors de l'étape de dépôt d'une couche de protection, la couche mince intermétallique est recouverte d'un empilement de couches minces diélectriques déposées par une ou plusieurs méthodes de dépôt sous vide, telles que par PVD, CVD ou ALD.

Dans des modes particuliers de mise en œuvre, lors de l'étape de dépôt d'une couche de protection, la composition et l'épaisseur des couches minces diélectrique de l'empilement de protection sont spécifiquement choisies pour conserver la couleur originale de la couche mince intermétallique ou pour modifier avantageusement la couleur de la couche mince intermétallique dans une direction choisie.

En particulier, les épaisseurs et compositions des couches minces diélectriques formant l'empilement de protection sont choisies de sorte à ce que les effets optiques interférentiels desdites couches minces diélectriques modifient la couleur de la couche mince intermétallique de manière esthétiquement avantageuse, par exemple en augmentant la saturation de la couleur ou en corrigeant la teinte dans une direction choisie.

Dans des modes particuliers de mise en œuvre, la couche de protection est une couche de polymère translucide déposée par sprayage ou toute autre méthode connue de l'homme du métier.

Dans des modes particuliers de mise en œuvre, la couche de protection est une couche composite avec des combinaisons de couches polymères et diélectriques déposées par les techniques connues de l'homme du métier.

L'invention concerne également, selon un autre aspect, un composant horloger comprenant un substrat comprenant un revêtement déposé par la mise en œuvre du procédé précité, ledit composant horloger présentant une couleur finale prédéterminée.

### Brève description des figures

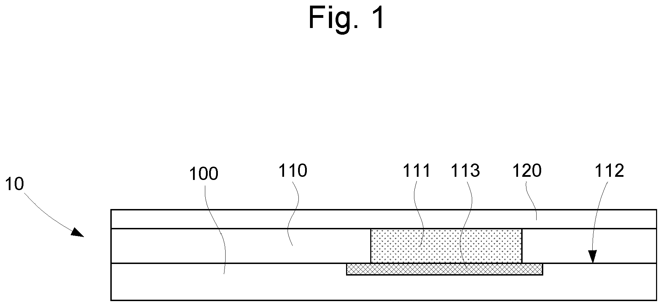

D'autres caractéristiques et avantages de l'invention apparaîtront à la lecture de la description détaillée suivante donnée à titre d'exemple nullement limitatif, en référence à la figure 1 représentant schématiquement une vue en coupe d'un composant horloger, tel qu'une pièce d'habillage, obtenu par la mise en œuvre d'un procédé de dépôt d'une couche intermétallique selon la présente invention.

### Description détaillée de l'invention

La présente invention concerne un procédé de dépôt d'un revêtement sur un substrat 100, ledit procédé comportant une étape de dépôt d'une couche mince intermétallique 110 sur le substrat 100 de sorte à obtenir une pièce d'habillage 10 d'horlogerie, de bijouterie ou d'articles de mode. En particulier, une telle pièce d'habillage 10 peut avantageusement former un composant horloger.

Le substrat 100 peut être réalisé dans tout matériau approprié, tel qu'en matériau métallique, céramique, etc.

L'étape de dépôt de la couche mince intermétallique 110 est mise en œuvre de sorte qu'une fois achevée, la couleur de la couche mince déposée corresponde à une couleur prédéterminée. Plus particulièrement, l'étape de dépôt de couche mince intermétallique 110 est mise en œuvre de sorte qu'à l'issue de cette étape, la pièce d'habillage 10 présente une couleur finale prédéterminée correspondant à ladite couleur prédéterminée de la couche mince intermétallique 110 déposée.

Autrement dit, le procédé est mis en œuvre de sorte qu'il ne soit pas nécessaire de réaliser une étape de recuit de la pièce d'habillage 10 pour cristalliser la couche mince intermétallique 110. Plus précisément, la composition de la couche mince intermétallique 110 est choisie de sorte qu'elle ait la couleur prédéterminée directement dans sa phase principalement amorphe et faiblement cristalline, telle que déposée à une température inférieure à 100°C avec la méthode de déposition choisie.

L'étape de dépôt de la couche mince intermétallique 110 est réalisée par la mise en œuvre d'une méthode de dépôt PVD et plus particulièrement par la mise en œuvre d'une des méthodes suivantes : pulvérisation cathodique ou ionique, évaporation thermique, évaporation par faisceau d'électrons ou par arc, ou ablation par faisceau laser pulsé.

Le dépôt de la couche mince intermétallique 110 est réalisé à partir d'au moins deux cibles composées chacune d'un métal propre et/ou à partir d'au moins une cible composée d'un composite d'au moins deux métaux.

Préférentiellement, pour simplifier la mise en œuvre de l'étape de dépôt de la couche mince intermétallique 110, celle-ci est réalisée à partir d'une cible composée d'un composite d'au moins deux métaux. Par ailleurs, les résultats obtenus lors de tests montrent que la composition de la couche mince intermétallique 110 est plus reproductible lorsque l'étape de dépôt de la couche mince intermétallique 110 est mise en œuvre à partir d'une unique cible composée d'un composite de métaux.

A titre d'exemple non-limitatif, les métaux utilisés sont choisis parmi Pt, Al, Cu, In et Au, ou parmi des composites de ces métaux.

Plus précisément, les métaux sont par exemple choisis de sorte que la couche mince intermétallique 110 comporte une combinaison intermétallique Au-Al, Au-ln, Pt-Al, ou Pt-Al-Cu.

L'étape de dépôt est réalisée de sorte que ladite couche mince intermétallique 110 mesure entre 20 et 1000 nm d'épaisseur, de préférence entre 200 et 500 nm, et plus préférentiellement 300 nm. Ainsi, la couche mince intermétallique 110 est avantageusement opaque et présente un bon compromis entre une épaisseur suffisamment importante pour que la couche mince intermétallique 110 soit adaptée à résister à des contraintes mécaniques qu'elle est susceptible de subir, et une épaisseur suffisamment faible pour que la consommation de métaux nobles et que la durée du dépôt de la couche mince intermétallique 110 ne soient pas trop élevées.

Le procédé de dépôt de la couche mince intermétallique 110 est mis en œuvre de sorte que ladite couche mince intermétallique 110 présente une phase principalement amorphe et faiblement cristalline suite à son dépôt.

Les paramètres de la méthode de dépôt PVD, notamment les puissances appliquées simultanément sur les différentes sources, ainsi que la composition de la cible composite le cas échéant, sont choisis de sorte que la couche mince intermétallique 110 obtenue ait une composition qui présente la couleur finale souhaitée après l'étape de dépôt de couche mince intermétallique 110.

À titre d'exemple non-limitatif, la couche mince intermétallique 110 peut être réalisée en composite Pt-Al-Cu dont la composition est de Pt 48.2%-masse, Al 11.2%-masse et Cu 40.6%-masse, l'étape de dépôt étant réalisée par co-pulvérisation cathodique à partir de 3 cibles respectivement de Pt, Al et Cu purs. A l'issue de l'étape de dépôt, une pièce d'habillage est obtenue, comportant une couche mince intermétallique faiblement cristallisée et une couleur caractérisée par les paramètres (L*, a*, b*) = (81.2, 6.6, 14.8). Elle présente donc une couleur finale orange.

De manière analogue, à titre d'exemple non-limitatif, la couche mince intermétallique 110 peut être réalisée en composite Pt-Al-Cu dont la composition est Pt 36.7%-masse, Al 14.3%-masse et Cu 49.0%-masse, l'étape de dépôt étant réalisée par co-pulvérisation cathodique à partir de 3 cibles respectivement de Pt, Al et Cu purs. A l'issue de l'étape de dépôt, une pièce d'habillage est obtenue, comportant une couche mince intermétallique faiblement cristallisée et une couleur caractérisée par les paramètres (L*, a*, b*) = (78.3, 6.5, 4.4). Elle présente donc une couleur finale rose.

Dans un autre exemple non-limitatif, la couche mince intermétallique 110 peut être réalisée en composite Pt-Al-Cu dont la composition est Pt 54.6%-masse, Al 12.8%-masse et Cu 32.7%-masse, l'étape de dépôt étant réalisée par co-pulvérisation cathodique à partir de 3 cibles respectivement de Pt, Al et Cu purs. A l'issue de l'étape de dépôt, une pièce d'habillage est obtenue, comportant une couche mince intermétallique faiblement cristallisée et une couleur caractérisée par les paramètres (L*, a*, b*) = (81.8, 4.3, 12.8). Elle présente donc une couleur finale jaune.

Avantageusement, bien que le procédé ne nécessite pas la mise en œuvre d'une étape de recuit sur l'ensemble de la pièce d'habillage pour obtenir une couleur prédéterminée, il peut comporter une étape de recuit localisé sur une zone prédéterminée 111 de la couche mince intermétallique 110.

Cette étape de recuit localisé a pour effet de modifier localement la couleur finale de la couche mince intermétallique 110, afin de générer une décoration, par exemple sous la forme d'indexes de cadrans, chiffres, logos, etc. En effet, le recuit a pour effet de modifier localement la phase de la couche mince intermétallique 110, en la faisant évoluer d'un état principalement amorphe et faiblement cristallin à un état cristallin, ce qui fait évoluer sa couleur, typiquement de sa teinte d'origine vers le gris.

L'étape de recuit localisé est réalisée à l'aide d'un laser dont le faisceau peut présenter un diamètre par exemple compris entre 10 µm et 100 µm, voire entre 50 µm et 100 µm. Le déplacement du faisceau laser est avantageusement contrôlé par un système de balayage propre au laser et basé sur des axes mécaniques ou optiques ou par un système de balayage propre au substrat basé sur des axes mécaniques apportant une importante précision de la position du point d'impact du faisceau laser sur la couche mince intermétallique 110.

Le faisceau laser a pour effet de générer localement, au niveau du point d'impact avec la couche mince intermétallique 110, une élévation locale de la température conduisant au changement de phase local de ladite couche mince intermétallique 110, et par conséquent au changement local de couleur.

Le faisceau laser peut être généré par un laser à impulsions nanosecondes ou à impulsions microsecondes, ou éventuellement par un laser continu.

Plus précisément, lors de l'étape de recuit localisé, le laser peut émettre des impulsions d'une durée comprise entre de 4 ns et 350 ns, de fréquence variable entre 10 kHz et 1 MHz, et pouvant atteindre une puissance moyenne de l'ordre de 40 W.

Alternativement, l'étape de recuit localisé peut aussi être mise en œuvre en utilisant des lasers à impulsions picosecondes ou femtosecondes, en utilisant l'effet d'accumulation thermique à haute cadence dans des fréquences allant de 100 à 200 kHz jusqu'à 10 MHz, ou des séries d'impulsions en rafales (connues par l'homme du métier sous le terme « bursts » en langue anglaise) espacées les unes des autres de quelques picosecondes à quelques nanosecondes.

La longueur d'onde du faisceau laser est déterminée de sorte à favoriser l'absorbance de la matière de la couche mince intermétallique 110 que le faisceau est destiné à impacter.

A titre d'exemple, le faisceau laser peut présenter une longueur d'onde comprise dans le spectre infrarouge, dans le spectre visible ou dans le spectre ultraviolet.

Lors de l'étape de recuit localisé, la variation de l'énergie des impulsions du faisceau laser, leur fréquence de répétition ainsi que leur degré de superposition conduisent à modifier la couleur de la couche intermétallique 110.

Il est ainsi possible de créer des décors multicolores ou contrastés sur la base d'un seul dépôt de couche mince intermétallique 110 de composition homogène.

Avantageusement, les étapes de dépôt et de recuit localisé de la couche mince intermétallique peuvent être précédées d'une étape de structuration de la surface 112 du substrat 100 dans laquelle une partie 113 de la surface 112 du substrat 100 est structurée de sorte à générer un contraste de structure de surface sur ladite surface 112.

En particulier, la partie structurée 113 de la surface 112 du substrat 100 peut correspondre à la zone prédéterminée 111 de la couche intermétallique 110 qui est soumise au traitement thermique lors de l'étape de recuit localisé. Ceci a pour effet avantageux de renforcer la différence entre l'aspect visuel de ladite zone prédéterminée 111 et celui du reste de la couche mince intermétallique 110.

Alternativement, dans une variante de réalisation de l'invention, la structuration est réalisée sur l'ensemble de la surface 112 du substrat 100.

Une telle étape de structuration de surface peut consister par exemple à polir, matifier ou satiner partiellement ou totalement la surface 112 du substrat 100, selon la variante de réalisation considérée.

Afin de faciliter l'étape de recuit localisé et de réduire l'apport local de chaleur nécessaire pour effectuer la transformation de phase de la couche mince intermétallique, la pièce d'habillage 10 peut être préchauffée à une température qui s'approche de la température de transition de phase. Ainsi l'apport d'énergie supplémentaire par laser peut être réduit.

Avantageusement, la couche mince intermétallique 110 obtenue après l'étape de dépôt peut être recouverte d'une couche de protection 120, par exemple formée par un empilement de couches diélectriques destiné à protéger la couche mince intermétallique 110 contre des agressions environnementales, lors d'une étape de dépôt ultérieure pouvant avantageusement être réalisée avec le même équipement de dépôt que celui employé pour mettre en œuvre l'étape de dépôt de la couche mince intermétallique 110. Cet empilement de couches minces diélectriques peut avoir également pour effet de modifier l'aspect visuel de la pièce d'habillage 10, par exemple d'en augmenter la brillance et/ou de modifier la couleur de la couche intermétallique 110 par un effet interférentiel avantageux.

L'étape de dépôt d'une couche de protection 120 est avantageusement la dernière étape du procédé selon l'invention.

L'empilement de couches minces diélectriques peut être formé de différents oxydes, nitrures, oxy-nitrures, tels que le TiO₂, Al₂O₃, SiO₂, SiN, Si3N4 et peut être déposé par une méthode de dépôt ALD et/ou PVD et/ou CVD.

Alternativement, l'étape de dépôt d'une couche de protection 120 peut consister à déposer une couche de vernis, par exemple une couche de vernis polymère du type zapon ou parylène.

Globalement, si le procédé selon la présente invention comporte l'ensemble des étapes précitées, elles sont mises en œuvre successivement en débutant par l'étape de structuration de surface du substrat 100, puis l'étape de dépôt d'une couche mince intermétallique 110 est réalisée, suivie de l'étape de recuit localisé, et enfin de l'étape de dépôt de la couche de protection 120.

L'invention propose ainsi une solution pour l'utilisation de composés intermétalliques, notamment à base de métaux nobles, offrant un large éventail de nouvelles couleurs pour des applications esthétiques dans l'horlogerie, la bijouterie et tout autre produit de luxe.

De manière plus générale, il est à noter que les modes de mise en œuvre et de réalisation considérés ci-dessus ont été décrits à titre d'exemples non limitatifs, et que d'autres variantes sont par conséquent envisageables.

## Revendications

1. Procédé de dépôt d'un revêtement sur un substrat (100), ledit procédé étant **caractérisé en ce qu'**il comporte une étape de dépôt d'une couche mince intermétallique (110) formée d'un composé intermétallique sur ledit substrat (100), de sorte à obtenir, à l'issue de cette étape, une pièce d'habillage (10) d'horlogerie, de bijouterie ou d'articles de mode présentant une couleur finale prédéterminée.

2. Procédé selon la revendication 1, dans lequel l'étape de dépôt de la couche mince intermétallique (110) est réalisée par la mise en œuvre d'une méthode de dépôt PVD parmi la pulvérisation cathodique ou ionique, l'évaporation thermique, l'évaporation par faisceau d'électrons ou par arc, ou l'ablation par faisceau laser pulsé.

3. Procédé selon la revendication 2, dans lequel le dépôt de la couche mince est réalisé à partir d'au moins une cible composée d'un composite d'au moins deux métaux ou d'au moins deux cibles de métaux purs différents.

4. Procédé selon l'une des revendications 1 à 3, dans lequel l'étape de dépôt de la couche mince intermétallique (110) est réalisée de sorte que ladite couche mince intermétallique (110) présente une épaisseur comprise entre 20 et 1000 nm, de préférence entre 200 et 500 nm, et plus préférentiellement de 300 nm.

5. Procédé selon l'une des revendications 1 à 4, comprenant une étape de recuit localisé sur une zone prédéterminée (111) de la couche mince intermétallique (110) de sorte à modifier localement la couleur finale de la pièce d'habillage (10).

6. Procédé selon la revendication 5, dans lequel l'étape de recuit localisé est réalisée par le biais d'un laser dont le faisceau présente un diamètre compris entre 10 µm et 100 µm.

7. Procédé selon l'une des revendications 5 ou 6, dans lequel l'étape de recuit localisé est réalisée par le biais d'un laser configuré pour émettre des impulsions dont la durée est comprise entre 4 ns et 350 ns, de fréquence variable entre 10 kHz et 1 MHz.

8. Procédé selon l'une des revendications 1 à 7, dans lequel l'étape de dépôt de la couche mince intermétallique (110) est précédée d'une étape de structuration de surface dans laquelle la surface (112) du substrat (100) est structurée.

9. Procédé selon la revendication 8 et l'une des revendications 5 à 7, dans lequel lors de l'étape de structuration, seule une partie (113) de la surface (112) du substrat (100) est structurée, ladite partie (113) correspondant à la zone prédéterminée (111) de la couche mince intermétallique (110) soumise à l'étape de recuit localisé.

10. Procédé selon la revendication 8, dans lequel lors de l'étape de structuration, la structuration est réalisée sur l'ensemble de la surface (112) du substrat (100).

11. Procédé selon l'une des revendications 1 à 10, comprenant, à la suite de l'étape de dépôt de la couche mince intermétallique (110) et de l'éventuelle étape de recuit localisé, une étape de dépôt d'une couche de protection (120).

12. Procédé selon la revendication 11, dans lequel lors de l'étape de dépôt d'une couche de protection (120), la couche mince intermétallique (110) est recouverte d'un empilement de couches minces diélectriques et/ou d'une couche de polymère translucide.

13. Procédé selon la revendication 11 ou 12, dans lequel lors de l'étape de dépôt d'une couche de protection (120), la composition et l'épaisseur des couches minces diélectrique de l'empilement de protection (120) sont spécifiquement choisies pour conserver la couleur originale de la couche mince intermétallique (110) ou pour modifier avantageusement la couleur de la couche mince intermétallique (110) dans une direction choisie.

14. Composant horloger comprenant un substrat (100), **caractérisé en ce que** ledit substrat (100) comprend un revêtement déposé par la mise en œuvre d'un procédé selon l'une des revendications 1 à 13, ledit composant horloger présentant une couleur finale prédéterminée.
